(19) **Europäisches Patentamt / European Patent Office / Office européen des brevets**

(11) **EP 2 325 667 B1**

(12) **EUROPEAN PATENT SPECIFICATION**

(45) Date of publication and mention
of the grant of the patent:
**16.01.2013 Bulletin 2013/03**

(51) Int Cl.:
***G01R 33/12*** *(2006.01)*

(21) Application number: **10191044.6**

(22) Date of filing: **12.11.2010**

(54) **Method and apparatus for determination of magnetic system manufacturing defects**

Verfahren und Vorrichtung zur Bestimmung von Mängel bei der Magnetsystemherstellung

Procédé et appareil pour la détermination des défauts pendant la fabrication d'un système magnétique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.11.2009 RU 2009141919**

(43) Date of publication of application:
**25.05.2011 Bulletin 2011/21**

(73) Proprietor: **Federalnoe Gosudarstvennoe Unitarnoe Predpriyatie "Nauchno-issledovatelskiy institut electrophizicheskoy apparatury im. D.V.Efremova Sankt-Petersburg 196641 (RU)**

(72) Inventors:
• **Amoskov, Viktor Mikhailovich**
  **197374 St. Petersburg (RU)**
• **Belyakov, Valeriy Arkadevich**
  **196641 St. Petersburg (RU)**
• **Vasiliev, Vyacheslav Nikolaevich**
  **191025 St. Petersburg (RU)**
• **Egorov, Sergey Alexandrovich**
  **197183 St. Petersburg (RU)**
• **Ivkin, Vladimir Georgievich**
  **196641 St. Petersburg (RU)**
• **Korotkov, Vladimir Alexandrovich**
  **196655 St. Petersburg (RU)**
• **Kukhtin, Vladimir Petrovich**
  **189630 St. Petersburg (RU)**
• **Lamzin, Evgeniy Anatolievich**
  **195279 St. Petersburg (RU)**
• **Lantsetov, Andrey Anatolievich**
  **196655 St. Petersburg (RU)**

• **Larionov, Mikhail Sergeevich**
  **196641 St. Petersburg (RU)**
• **Maximenkova, Nina Alexandrovna**
  **196641 St. Petersburg (RU)**
• **Rodin, Igor Yurievich**
  **196653 St. Petersburg (RU)**
• **Sytchevsky, Sergey Evgenievich**
  **197101 St. Petersburg (RU)**
• **Filatov, Oleg Gennadievich**
  **196641 St. Petersburg (RU)**
• **Firsov, Alexey Anatolievich**
  **196641 St. Petersburg (RU)**
• **Shatil, Nikolay Alexandrovich**
  **192174 St. Petersburg (RU)**

(74) Representative: **Viering, Jentschura & Partner Grillparzerstrasse 14 81675 München (DE)**

(56) References cited:
**US-A- 5 654 635     US-A1- 2001 054 509**

• **BELYAKOV V ET AL: "Plasma control in Tokamaks", PHYSICS AND CONTROL, 2005. PROCEEDINGS. 2005 INTERNATIONAL CONFERENCE SAINT PETERSBURG, RUSSIA AUG. 24-26, 2005, PISCATAWAY, NJ, USA,IEEE, 24 August 2005 (2005-08-24), pages 920-927, XP010839639, ISBN: 978-0-7803-9235-9**
• **DUKE A E ET AL: "Coupled Electromagnetic and Thermohydraulic Analysis of the ITER Cable Joint", IEEE TRANSACTIONS ON APPLIED SUPERCONDUCTIVITY, IEEE SERVICE CENTER, LOS ALAMITOS, CA, US, vol. 7, no. 2, 1 June 1997 (1997-06-01), XP011081401, ISSN: 1051-8223**

**Description**

TECHNICAL FIELD

The invention relates to the method for determination of defects arising in manufacturing, assembling and mounting magnetic systems, i.e. structures comprising current coils or permanent magnets and serving as magnetic field sources. The invention can be used in manufacturing and adjustment of electrophysical equipment but its use is not limited to these applications.

BACKGROUND OF THE INVENTION

There are a lot of structures of different complexity generating magnetic field in the ambient space, and the generated magnetic field should meet certain requirements on its configuration and orientation in the space. Such structures are generally called magnetic systems.

There are severe requirements for magnetic system quality. Direct control of manufacturing, assembly and mounting quality is usually complicated due to limited accessibility or high dimensions of structures; in other words the methods based on direct measurement of size deviations are difficult or impossible to apply. On the other hand the magnetic system will generate magnetic field different from required performance when such a system is assembled with the use of defective components even if geometric parameters comply with the requirements. At the same time magnetic systems are meant for generation of magnetic field with predetermined parameters, and information based on magnetic field distribution in the ambient space can be used for assessment of the manufacturing quality and operational integrity of the system and its components.

If the magnetic system is assembled properly, its magnetic field coincides with the calculated field map; otherwise the magnetic field will mismatch the specified performance. The term "a defect" set forth below means a specific deviation made in the course of manufacturing, assembling or mounting the magnetic system under consideration and exceeding targeted technological tolerances.

Use of magnetic field measurement for a quality control is known in the state of the art. For example, a magnetic field sensor placed on the axis of a round dc coil can be used for checking absence of short-circuited turns in the coil. The sensor signal is proportional to the number of coil turns and in case of short-circuited turns, the sensor signal is lowering and from its decreasing value the number of short-circuited turns can be evaluated (see I.E. Tamm, Bases of the Electricity Theory, Nauka, Moscow, 1989).

Thus, well-known systems using magnetic field measurement can give an answer to the following questions: whether an apparatus is assembled properly and whether its elements are functional. Information about nature (type), value and location of a defect is typically obtainable only in the simplest cases.

For the most of engineering problems it is necessary to know the information on either nature (type) or value and location of the defect. The defect location should be often determined in an area generally completely closed for visual observation.

A typical example of a magnetic system is a superconducting cable used in electromagnetic coils as an element applied to magnetic field generation. The cable is formed by twisted strands consisting of a large quantity of wires, and if there is a defective wire, a field distribution near the defective strand is changed.

From US 2001/054509 A1 it is known to model distribution of currents on the base of the measured inductances and resistances. The method comprises solving equations for modeling the defects through current losses. This technical decision allows to calculate magnetic field with use of the current distribution and thus to calculate the magnetic field of the defect as well. The disclosed method of the defect determination requires the measuring of inductances and resistances, which could be unavailable in many cases.

Another document, Duke A.E. et al.: "Coupled Electromagnetic and Thermohydraulic Analysis of ITER Cable Joint", IEEE TRANSACTIONS ON APPLIED SUPERCONDUCTIVITY, Vol. 7, No. 2, June 1997, discloses determination of Joule loss in superconductor joints on the base of distribution of transport currents and eddy currents. The eddy currents in the cable joints are proposed to be defined with use of Biot-Savart formula applied to the determined current distribution. The method allows evaluating Joule loss with use of current distribution model, however there was not described a possible way to determine defects of a magnetic system.

The electromagnetic coils per se can be another example of a magnetic system. These coils often have dimensions of about several meters and masses of tens kilograms, but they should be mounted with accuracy of millimeters. In this case the defect can be not only a winding flaw but a coil misplacement from the predetermined location as well. Ideally the coil location should relate not to its geometrical dimensions but to the current distribution in the coil.

A structure consisting of permanent magnets can be yet another example of a magnetic system with one of the magnets mounted incorrectly. Such systems are used as static field sources in tracking systems, see patents RU 2197013 "Procedure and tracking system establishing position and orientation of mobile object" and RU 2241958 "Method and follow-up for finding position of and location of moving object".

The patent US 5654635 discloses a method and device for correcting measurement errors of a magnetometer (magnetic field measurement system) mounted in a vehicle, e.g. an aircraft or helicopter. The method comprises measuring a magnetic field distorted by a magnetic system (a vehicle) by magnetic field sensors located inside the vehicle. An equation associating the measured magnetic field with hypothetical error magnetic fields introduced by the magnetic system is formulated, wherein the hypothetical error magnetic fields depend on one or more parameters. Solving of the formulated equation allows obtaining of values of the parameters. These values determine error magnetic fields introduced by the magnetic system. That method is directed to correct measured values of a magnetic field in order to obtain the parameters of the magnetic field without error magnetic fields introduced by the magnetic system, for example an aircraft or helicopter. The disclosed method does not provide determination of defects of the magnetic system. Moreover, this method needs to carry out measurements inside the magnetic system; however it is not possible in some cases.

A problem of defect location determination with the use of field measurement outside a magnetic system cannot be solved in general case. For example, assuming that the current is flowing in an infinite cylinder with the radius of R and knowing that the exact field distribution in space is inversely as a distance from the cylinder axis, there is no way to determine the current distribution in this cylindrical wire, because such a field can be generated not only with a homogeneous solid cylindrical wire, but with any wire having the cylindrical symmetry, see I.E. Tamm, Bases of the Electricity Theory, Nauka, Moscow, 1989. The above-mentioned is also correct for defects associated with manufacturing, assembling and mounting.

Further prior art is disclosed in Belyakov V. et al.: "Plasma control in Tokamaks", Physics and Control, Proc. Intern. Conf. Saint Petersburg, Russia, Aug. 24-26, 2005, Piscataway, NJ, USA, IEEE, 24.08.2005, pp. 920-927. According to this publication, a magnetic field of the magnetic system is measured by using at least one magnetic field sensor located outside a magnetic system. To recognize defects of the magnetic system, at least one equation associating the measured magnetic field with a hypothetical magnetic field of the magnetic system having at least one hypothetical defect introduced therein, is formulated. Further, the hypothetical magnetic fields of the magnetic system having at least one hypothetical defect introduced therein are assessed through the statistical approach with Monte Carlo simulations and they allow to determine deviations (defects) expected during the manufacture and assembly of the magnetic system. The method of evaluating the error field takes lot of time for its implementation and requires significant computational power.

Typically, a set of possible technological defects in the process of manufacturing, assembling or mounting can be selected for any considered structure. Such "typical technological defects" can be mathematically described by a set of parameters.

Thus, lost of conductivity in an individual strand can be referred to main manufacturing defects of the superconducting cable. Such a defective strand is mathematically described by its center location in the cable section plane.

Displacement and tilt with respect to other components as well as winding deformations are the main manufacturing defects of the electromagnetic coils. They are mathematically described with a coil center displacement vector, an angle of inclination and semi-axes of an ellipse, correspondingly.

Misalignments in prescribed locations and variation of magnetization of individual magnets relate to the main manufacturing defects of the permanent magnet system. They are mathematically described with a displacement vector and a magnetization vector.

Due to use of the method and the apparatus in accordance with above-mentioned technical solution only correctness of structure manufacturing, assembling or mounting can be determined. A disadvantage of the known method and apparatus is that there is no additional information about the nature of the defect or this information is qualitative.

SUMMARY OF THE INVENTION

An object of the present invention is to provide a method and an apparatus for determination of the presence, location and parameters (i.e. quantitative adjectives) of defects of a magnetic system through examination of magnetic field in the vicinity of the magnetic system. An additional object of the present invention is improvement of determination accuracy of magnetic system defect parameters.

The object of the present invention is solved by a method for determining defects in a magnetic system, the method comprising the steps of:

- measuring, by using at least one magnetic field sensor located outside a magnetic system, a magnetic field of the magnetic system;
- formulating at least one equation associating the measured magnetic field with a hypothetical magnetic field of the magnetic system having at least one hypothetical defect introduced therein; and
- solving the at least one formulated equation.

The method is characterized in that the method comprises, before the step of measuring the magnetic field, the steps of:

- introducing the at least one hypothetical defect into the magnetic system and defining at least one parameter defining the at least one hypothetical defect;
- simulating the hypothetical magnetic field of the magnetic system having the at least one hypothetical defect introduced therein;
- determining points for locating the at least one magnetic field sensor;
- determining a number of measurements of the magnetic field;

wherein the hypothetical magnetic field depends on one or more parameters defining the at least one hypothetical defect, and
wherein values of the parameters are determined by solving the at least one formulated equation to obtain, the values determining defects in the magnetic system.

The hypothetical magnetic field of the magnetic system can be defined on the base of simulation using well-known mathematical models of magnetic field such as the Biot-Savart-Laplace law, the Maxwell equations or the like.

A set of typical defects of the magnetic system to be measured is considered to be known in advance, wherein the typical defects are interpreted as technological errors in manufacturing, assembling and mounting a specific structure as well as failures of the system and its elements, which could be predicted in advance; wherein a number of defect types is supposed to be limited to a certain list in accordance with the magnetic system structure and the technology of manufacturing and assembling.

The measured field is considered to be a superposition of fields generated by an ideal magnetic system (i.e. a structure without defects) and by all the defects. The list of possible defects is compiled and a set of undetermined parameters to be determined, which describe every type of the defects, is stated on the base of the manufacturing technology and given design features (it can be done in advance prior to the measurement fulfillment). A magnetic field distribution for every defect from the list of possible defects is determined as a result of simulation of magnetic field of a system..

The formulated equations form a system of equations; by solving it, the defect parameters to be sought are determined. Preferably a number of measurement points and therefore a number of the equations compiled based on the sensor signals should be not less than a general number of independent parameters describing the defects to be determined.

Preferably, the size and the shape of the magnetic system vicinity, i.e. the area, which the magnetic field measurements are carried out in, are defined through preliminary simulation of said magnetic system defects. The measurement points, wherein the magnetic field sensors are placed, or optimal spatial arrangement of the magnetic field sensors in the magnetic system vicinity in the case of plurality of the sensors and/or the orientation of at least one magnetic field sensor can be determined on the base of requirements regarding accuracy of determination of the parameters describing defects. While determining the magnetic field measurement points, required accuracy of both the positioning and the orientation of the magnetic field sensor can be determined. Required measurement accuracy of the magnetic field sensor can be specified on the base of the preliminary simulation; in another case measurement accuracy of the magnetic field sensor can be taken as, for example, accuracy of available sensors, and the measurement point or sensor locations are varied to achieve required determination accuracy of the magnetic system defects.

As can be seen above, the sensor location and orientation as well as their positioning accuracy can be set based on preliminary simulation. However even in this case there is a sensor positioning error and in a preferable embodiment while measuring magnetic field near the magnetic system, location and orientation of at least one measuring sensor are determined to determine actual sensor location and orientation. In case of sensor positioning in a rough way, for example, within a certain area, location and orientation determination of the magnetic field sensors on the course of the measurement fulfillment is necessary.

In one embodiment the method in accordance with the present invention is performed in a magnetic system comprising at least one current-carrying conductor, wherein in one of the variants this conductor is a cable. Said cable can be superconducting; in this case the defect is cable strand breakage, and parameters describing the defects are conductor center point coordinates, winding pitch and defective portion length (five parameters in all).

In another embodiment the method in accordance with the present invention is performed in a magnetic system comprising at least one electromagnetic coil, wherein in one of the cases the system consists of a single electromagnetic coil. In this case, if the electromagnetic coil is round, the defects are coil ellipticity and warping with respect to the other component included into the system or being outside the system, and parameters describing the defects are major and minor semi-axes of the ellipse and maximum vertical distortion (three parameters in all). If the electromagnetic coil is a tokamak toroidal field coil, the defects are displacements of N reference points of the coil central line, wherein parameters describing the defects are displacements ($\Delta x$, $\Delta y$, $\Delta z$) of every N reference points (3N parameters in all).

In one more embodiment the method in accordance with the present invention is performed in a magnetic system comprising at least one permanent magnet, wherein in one of the cases the system consists of a single permanent magnet. In this embodiment the defect is magnetic moment change of the equivalent point dipole, wherein parameters describing the defects are changes of the magnetic moment components ($\Delta Mx$, $\Delta My$, $\Delta Mz$) (three parameters for every permanent magnet in all).

The method in accordance with the present invention can be also performed for a magnetic system comprising at least two elements generating magnetic field, wherein defects are space displacement and tilt of at least one element with respect to the other one, and parameters describing the defects are three displacement coordinates and three Euler angles of the tilt, i.e. six parameters in all. In this case magnetic system elements are positioned with respect to each other.

In a further embodiment the method is performed in a magnetic system comprising at least one element generating magnetic field, wherein defects are space displacement and tilt of at least one element generating magnetic field and included into the magnetic system, with respect to at least one element not included into the magnetic system or with respect to at least one element included into the magnetic system but not generating magnetic field, and parameters describing the defects are three displacement coordinates and three Euler angles of the tilt. In this embodiment the magnetic system elements can be positioned, for example, with respect to the reference elements not included into the system, for example, with respect to marks labeled on building walls or with respect to satellites included into the Global Positioning System (GPS). On the other hand, the elements being references for orienting the magnetic system elements generating useful magnetic field can be standard components of the magnetic system, wherein said components intended for magnetic system element orienting preferably do not generate own magnetic field or generate magnetic field, which can be neglected due to smallness or location, where said magnetic field does not influence the system useful magnetic field.

While implementing the method in accordance with the present invention, further simulation of magnetic field of the system without defects can be fulfilled; wherein during formulation of said system of equations the values of the magnetic field corresponding to the magnetic system without defects are subtracted from the measured values of the system magnetic field.

In one embodiment of the invention during formulation of the equations the measured magnetic field is related with the hypothetical magnetic field of the magnetic system at the magnetic field measurement points.

In another embodiment of the invention during formulation of the equations, the hypothetical magnetic field of the magnetic system is related with the magnetic field values obtained on the base of the measured values of the magnetic field at the points within an area enclosing the magnetic system, wherein the magnetic field measurement points are placed at the boundary of the area. The magnetic field values obtained on the base of the measured values of the magnetic field are evaluated at said points within said area through finding a solution to the boundary value problem of the Laplace equation.

In this case magnetic field measurements are made with the use of the sensors at the boundary of one or more enclosed volumes (vicinities or measurement areas), wherein location of said volumes and sensor arrangement are defined by preliminary mathematical simulation such as described in RU2271549 "Method and device for magnetic field mapping in a closed volume". The direct measurement data are interpolated with respect to said measurement area boundary to calculate the magnetic field at the boundary points. The interpolation data with respect to the measurement area boundary are used as the boundary data to find a solution to the boundary value problem of the Laplace equation, wherein during formulation of the system of equations the boundary value problem of the Laplace equation is solved, the magnetic field values at the inner points of the area are calculated and these values are used to formulate the system of equations. Due to the fact that a field sensor measurement error being the difference of two harmonic functions (of the calculated and measured magnetic fields) is a harmonic function itself, the error has a maximum value at the area boundary in accordance with a well-known feature of harmonic functions. In that way a direct field measurement error connected to sensor noise as well as to sensor coordinates measurement errors is reduced.

In a further embodiment of the method, measurement of the magnetic field of the magnetic system comprising at least one current-carrying conductor is fulfilled when the current in the magnetic system is zero, wherein such measured magnetic field values are subtracted from the magnetic field values measured with the current in the magnetic system being nonzero, and the obtained values are used to formulate said system of equations. This embodiment of the method is used when there is constant interfering magnetic field or when terrestrial magnetic field influence is significant or when there is significant sensor data drift with time.

In a further embodiment of the method, measurement of the magnetic field of the magnetic system comprising at least one current-carrying conductor is also carried out when the current in the magnetic system is inverse, wherein the system magnetic field values are determined by calculation of half-difference of values of the magnetic fields generated by the direct and inverse currents in the magnetic system, and the obtained values are used to formulate said system of equations. This embodiment of the method is also used when there is a constant interfering magnetic field or when the terrestrial magnetic field influence is significant or when there is the significant sensor data drift with time.

The object of the present invention is also achieved with an apparatus for determination of defects of a magnetic system or its components being magnetic field sources, the apparatus comprises: at least one magnetic field sensor located outside a magnetic system, configured to measure a magnetic field of the magnetic system; and data processing means configured to:

- formulate at least one equation associating the measured magnetic field with a hypothetical magnetic field of the magnetic system having at least one hypothetical defect introduced therein, the hypothetical magnetic field depending on one or more parameters defining the at least one hypothetical defect; and
- solve the at least one formulated equation to obtain values of the parameters, the values determining defects in the magnetic system.

In a preferable embodiment of the apparatus the sensors are mounted on a movable frame encompassing a closed domain, wherein the apparatus is provided with the means for driving frame and means for sensor positioning control.

The magnetic field sensors are preferably single-component.

The method and the apparatus in accordance with the invention provide possibility for detection of magnetic system defect and its parameter determination, and eliminate the main disadvantage of the known technical solutions, which is absence of quantitative information about the defects. Furthermore the present invention provides improved accuracy for determination of the magnetic system defect parameters.

The method and the apparatus for the magnetic system defect determination provide exact determination of type, location and size of a defect, and thus allow eliminating the defects with less time for defect localization and its value determination as well as its elimination. The exact determination of defect parameters reduces material losses and expenses for defect elimination due to the fact that defect location and size become known prior to beginning the defect elimination work.

BRIEF DESCRIPTION OF THE DRAWINGS

Fig. 1 shows a block diagram of an apparatus for defect determination.
Fig. 2 shows a general view of a superconducting cable.
Fig. 3 shows a superconducting cable cross-section.
Fig. 4 shows a general view of a tokamak poloidal coil.
Fig. 5 shows a view of elliptical distortion of the poloidal coil.
Fig. 6 shows a view of warping of the poloidal coil.
Fig. 7 shows a general view of a tokamak toroidal coil.
Fig. 8 shows a view of a toroidal coil having distortions.
Fig. 9 shows a system of permanent magnets generating reference magnetic field in an aircraft tracking system.

DETAILED DESCRIPTION

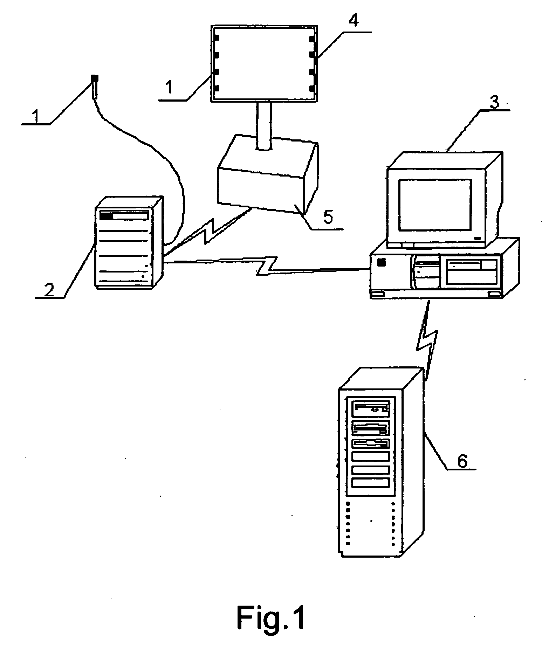

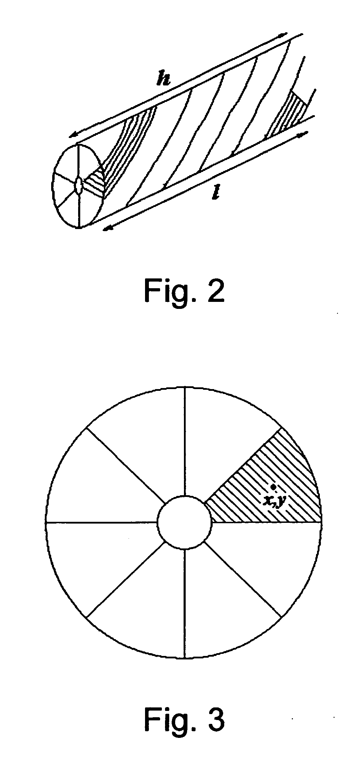

Fig. 1 shows a block diagram of an apparatus for defect determination. Examples of apparatuses and typical defects are illustrated in Figs. 2-4.

The apparatus comprises a frame 4 having at least one magnetic field sensor 1, means for sensor signal receiving and transmitting said signals to means 2, data acquisition system with a memory block and a processing block (a computer 3) for measurement data storage. In a preferable embodiment of the apparatus the sensors 1 are mounted on a movable frame encompassing a closed domain, wherein the apparatus is provided with means 5 for driving the frame and means for sensor coordinates and orientation determination. The processing block can be combined with the computer 3 controlling measurements, but it is preferable to have a separate high-performance computer 6. The processing block is intended to store a database of a of magnetic field map generated by the "typical defects" of an electromagnetic structure. Solving a system of algebraic equations, the processing block determines parameters to be used for "typical defects" description (see below).

A number of single-component sensors is defined through preliminary mathematical simulation. Single-component magnetic field sensors are well-known in the state of the art; see M.L. Baranochnikov "Micromagnetoelectronics", v. 1-2, Moscow, DMK-Press, 2001.

Means for sensor signal transmitting to the computer 3 are implemented on a printed circuit board and have an embedded microcontroller synchronizing analog-to-digital converters transforming sensor signals into digital form. The computer is provided with a memory block, for example, a permanent storage for storing magnetic field sensor coordinates.

To determine magnetic system defects by using the described apparatus, system magnetic field is measured near the magnetic system with the use of at least one magnetic field sensor. Further at least one equation connecting the measured magnetic field to the hypothetical magnetic field of the magnetic system having one or more defects is composed (formulated) in the data acquisition system, wherein the hypothetic magnetic field is expressed in the form of dependence on one or more parameters, whereupon the formulated equations are solved to obtain the parameters describing the defects.

A number of measurements, positions and/or orientations of the sensors measuring the magnetic field can be defined arbitrarily; however in a preferred embodiment prior to the step of magnetic field measurement, at least one parameter describing said defect is set, preliminary simulation of the magnetic field of the magnetic system having more defects is carried out and magnetic field measurement points and/or the orientation of at least one magnetic field sensor as well as the number of measurements are determined.

Further a preferable algorithm for parameter determination of a "typical defect" is described and the preliminary simulation of a magnetic system field is carried out in accordance with it.

Let all of $N$ listed parameters describing the typical defects of a specific system be presented as a generalized vector:

$$\vec{a} = (a_1, a_2, ..., a_N) \qquad (1)$$

No other magnetic system defects are assumed possible in accordance with the manufacturing technology, i.e. this vector completely defines all of the "typical defects". Examples of such parameters are shown on Figs. 2 to 4.

To provide the parameters (1) determination the number of field measurements fulfilled in $K$ points near the given system (the number of equations) should be not less than the number of parameters (1), i.e. $K \geq N$. The measurements are preferably carried out by single-component sensors. Using these data the parameters (1) can be determined with the use of the following method.

The magnetic field sensor measures the magnetic field vector component directed along a sensor magnetic axis:

$$b_k = (\vec{B}_k \cdot \vec{n}_k), \qquad (2)$$

where $b_k$ is the field component measured by the $k$ sensor, $\vec{B}_k$ is the system magnetic induction vector in the center of the $k$ sensor sensing area and $\vec{n}_k$ is the unit vector of the $k$ sensor magnetic axis direction.

The expression (2) includes two vectors: $\vec{B}_k = (B_x, B_y, B_z)$ and $\vec{n}_k$.

Methods of determination of the unit vector of the sensor magnetic axis direction are well-known in the state of the art (Afanasiev U.V., Studentsov N.V., Schepkin A.P. "Magnetometric converters, devices, apparatuses", Moscow, Energiya, 1972). They are based on sensor rotation in known calibrating field, for example, magnetic field of the Earth.

The magnetic field vector $\vec{B}_k$ is calculated at a point $\vec{r}_k = (x, y, z)$ located in the center of the $k$ sensor sensing area. Each sensor coordinates can be directly measured with a vernier height gauge, for example.

Calculation of a vector of magnetic induction generated by current coils or permanent magnets is well-known in the state of the art (see I.E. Tamm, Bases of the Electricity Theory, Nauka, Moscow, 1989; Purcell E. "Electricity and Magnetism"). Note that the magnetic field sources locations are usually supposed to be exactly known in the published sources, while the magnetic field sources depend on the parameters (1) in the considered case. Nevertheless if the parameters (1) are assumed to have some (arbitrary) values the magnetic field vector can be calculated in principle by using formulas known from literature.

Thus the calculated magnetic induction vector in the k point depends on the set of parameters (1):

$$\vec{B}_k = \vec{B}_k(a_1, a_2, ..., a_N) = \vec{B}_k(\vec{a}) \qquad (3)$$

If the product in the right part of the formula (2) is designated as $f_k$, then the following expression for this function can be written:

$$f_k(\vec{a}) = (\vec{B}_k(\vec{a}), \vec{n}(\vartheta, \varphi)); \qquad (4)$$

that depends on all of the parameters (1) too.

Calculated magnetic field (4) as a function of the $N$ unknown variables (1) must be equal to the magnetic field $b_k$ value measured by the sensor and it gives a system of $K \geq N$ nonlinear algebraic equations:

$$f_k(a_1, a_2, ..., a_N) = b_k, \qquad (5)$$

where $k=1...K$.

The system of equations (5) depending on the variables (1) is solved, for example, through finding the discrepancy functional $F$ minimum:

$$F = \left\{ \sum_k (B_k - b_k)^2 + \alpha \sum_i (a_i - a_i^{\bullet})^2 \right\} \qquad (6)$$

where $a_i^{\bullet}$ is an arbitrary set of the generalized coordinates (1) and $\alpha$ is a regularization parameter (see Tikhonov A.N., Arsenin V.Y. "Methods of incorrect problem solving", Moscow, Nauka, 1986).

Functional (6) minimization can be fulfilled with use of an iterative procedure, for example, a generalized Newton method (see Demidovich B.P., Maron I.A. "Bases of the calculus mathematics", Moscow, Nauka, 1970). In view of this all of $N$ partial derivatives $\partial F / \partial x_i$ of the functional (6) over the variables (1) are set equal to zero and it gives a system of linear equations with positively defined matrix of $N*N$ dimension:

$$\left( D^T D + \alpha E \right) \Delta \vec{a} = D^T \Delta \vec{B} + \alpha (\vec{a}^{\bullet} - \vec{a}) \qquad (7)$$

where $D_{ki} = \dfrac{\partial f_k(\vec{a})}{\partial a_i}$, $\Delta B_k = f_k(\vec{a}) - b_k$, $k=1...K$, $i=1...N$, and $D^T$ is the matrix transposed with respect to the derivative matrix $D$.

The linear system (7) is solved relative to $N$ increments $\Delta \vec{a}$ = ($\Delta a_1$, $\Delta a_2$ ,..., $\Delta a_N$) using the Gaussian method (see Demidovich B.P., Maron I.A. "Bases of the calculus mathematics", Moscow, Nauka, 1970). A regularization parameter $\alpha$ determination is described in the monograph Tikhonov A.N., Arsenin V.Y. "Methods of incorrect problem solving", Moscow, Nauka, 1986.

Let $(a_1^{(0)}, a_2^{(0)}, ..., a_N^{(0)})$ be a certain initial approximation of the generalized coordinates (1) vector; for convenience, when defects are absent, values of parameters (1), can be taken as it. By repeating the iterative procedure (7) of the generalized Newton method a necessary number of times, all of the unknowns (1) could be calculated with the required accuracy. Thus the set task is solved.

At least the $N$ equations are necessary for a correct solution of the system (5), but a redundant number of equations is preferable to use for increasing solution accuracy and reliability.

The disclosed method of the defect presence, location and parameter determination can be fulfilled in a magnetic system comprising at least one current-carrying conductor, wherein in one of the variants this conductor is a cable. Said cable can be a superconducting one; in this case the defect is cable strand breakage and parameters describing the defects are strand center point coordinates, the winding pitch and the defective portion length (five parameters in all). The Fig. 2 shows a general view of a superconducting cable being formed by twisting several (for example, eight) strands. A typical defect can be conduction failure in the strand (such a strand is hatched on the Fig. 2). The defect parameters are the winding pitch $h$, the defective portion length $l$ and strand center point coordinates *(x, y)* shown on the Fig. 3.

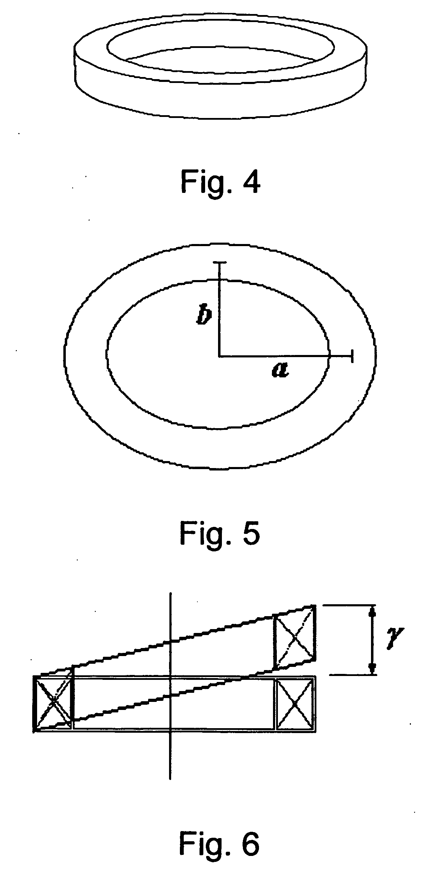

The disclosed method can be also fulfilled in a magnetic system comprising at least one electromagnetic coil, wherein in one of the cases the system consists of a single electromagnetic coil. In the case, when the electromagnetic coil is round, the defects are coil ellipticity and thewarping with respect to the other components included into the system or being outside the system, and the parameters describing the defects are major and minor semi-axes of the ellipse and the maximum vertical distortion (three parameters in all). Fig. 4 shows such a coil, wherein Fig. 5 shows elliptical distortion of the coil with the ellipse semi-axes *a* and *b*, and Fig. 6 shows coil vertical distortion with a value of $\gamma$.

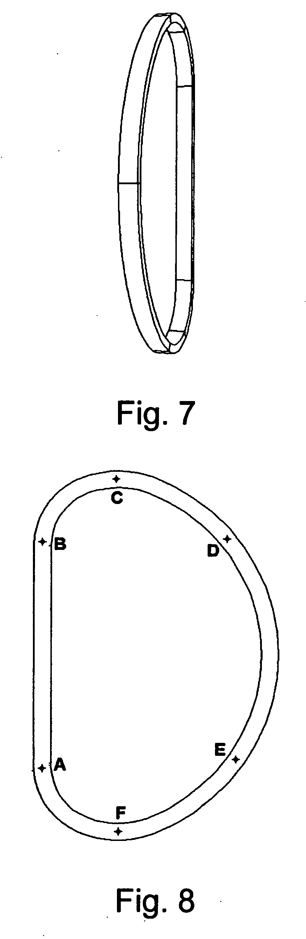

The electromagnetic coil can be a tokamak toroidal field coil; in this case the defects are displacements of N reference points of the coil central line, wherein parameters describing the defects are displacements ($\Delta x$, $\Delta y$, $\Delta z$) of every N reference point (3N parameters in all). Fig. 7 shows a general view of a tokamak toroidal coil and Fig. 8 shows typical defects in manufacturing, which regard to distortion of the coil central current line. The coil central current line can be described by a spline passing through several reference points to be checked; Fig. 8 shows a variant of six points A to F. The defect parameters are reference point displacements, i.e. $\Delta x_A$, $\Delta y_A$, $\Delta z_A$, $\Delta X_B$, $\Delta y_B$, $\Delta z_B$, ..., $\Delta x_F$, $\Delta y_F$, $\Delta z_F$.

The described method can be also fulfilled in a magnetic system comprising at least one permanent magnet, wherein in one of the cases the system consists of a single permanent magnet. In this embodiment the defect is magnetic moment change of the equivalent point dipole, wherein the parameters describing the defects are changes ($\Delta Mx$, $\Delta My$, $\Delta Mz$) of the magnetic moment components (three parameters for every permanent magnet in all).

Further, the method in accordance with the present invention can be also fulfilled in a magnetic system comprising at least two elements generating magnetic field, wherein the defects are space displacement and tilt of at least one element with respect to the other one, and the parameters describing the defects are three displacement coordinates and three Euler angles of the tilt, i.e. six parameters in all. In this case the magnetic system components are positioned with respect to each other.

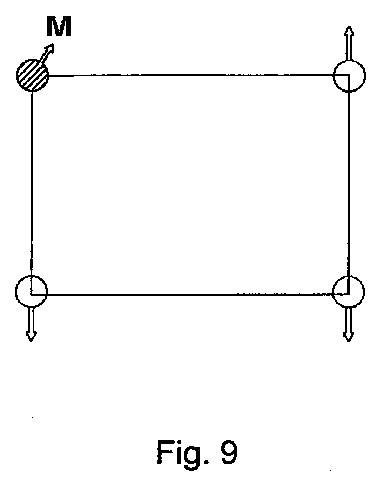

Fig. 9 shows a magnetic field source used in an airplane tracking system and consisting of several (for example four) permanent magnets, which can be cited as an example of such a system. Every magnet is defined by the magnetic moment **M** of the equivalent dipole. A manufacturing defect is considered to be the change of the magnetic moment ($\Delta M_x$, $\Delta M_y$, $\Delta M_z$) of one or more magnets. Fig. 9 shows a case when one of four magnets is deflected from the vertical position prescribed for mounting.

In one embodiment the method is fulfilled in a magnetic system comprising at least one element generating magnetic field, wherein the defects are space displacement and tilt of at least one element generating the magnetic field and included into the magnetic system with respect to at least one element not included into the magnetic system or with respect to at least one element included into the magnetic system but not generating magnetic field, and the parameters describing the defects are three displacement coordinates and three Euler angles of the tilt.

While performing the method in accordance with the present invention, simulation of magnetic field of the system without defects can be further fulfilled; wherein during formulation of said system of equations the values of the magnetic field corresponding to the magnetic system without defects are subtracted from the measured values of the system magnetic field.

In one embodiment of the invention during formulation of the equations, the measured magnetic field is related with the hypothetical magnetic field of the magnetic system at the measurement points. However with the aim of more precise determination of defect location and parameters during formulation of the equations, the hypothetical magnetic field of the magnetic system is preferably related with the magnetic field values obtained on the base of the measured values of the magnetic field at the points within an area enclosing the magnetic system, wherein the magnetic field measurement points are placed at the boundary of the area. The magnetic field values obtained on the base of the measured values of the magnetic field are evaluated at said points within said area through finding a solution to the boundary value problem of the Laplace equation.

Provided that a magnetic system comprises at least one current-carrying conductor, with the aim of defect location and parameter determination accuracy increase, magnetic system magnetic field measurement is performed when the current in the magnetic system is zero, wherein measured in such a way magnetic field values are subtracted from the magnetic field values measured with the current in the magnetic system being nonzero, and the obtained values are used to formulate said system of equations. In a similar case another method of defect location and parameter determination accuracy increase can be used. In accordance with this method measurement of magnetic field of a magnetic system comprising at least one current-carrying conductor is also carried out when the current in the magnetic system is inverse, wherein the system magnetic field values are determined by calculation of half-difference of the values of magnetic fields generated with the direct and inverse currents in the magnetic system, and the obtained values are used to formulate said system of equations.

The disclosed apparatus and method for magnetic system defect determination in accordance with the present invention allow determining defect presence or absence, and if the defects are present they make possible to determine the defect parameters and locations. Further, some disclosed aspects of the invention also allow increasing the magnetic system defect parameter and location determination accuracy in case of defect presence.

The proposed method and apparatus for the magnetic system defect determination allow to reduce the time for defect detection and to determine defect parameters and location as well, and thus allow eliminating the found defects with less material and labor costs. This in turn positively influences the cost of mounting work and magnetic system maintenance work as well as reducing replaceable element expenses, because exact determination of the magnetic system defect parameter and location provides possibility of defect elimination through replacement of the minimum required quantity of the elements generating magnetic field in the vicinity of the found defect. Further, determination of presence, location and parameters of defects of such magnetic system elements as a superconducting cable allows rejection of defective elements of toroidal tokamak prior to or during mounting and thus reduces defect elimination costs as well.

**Claims**

1.  A method for determining defects in a magnetic system, the method comprising the steps of:

    - measuring, by using at least one magnetic field sensor (1) located outside a magnetic system, a magnetic field of the magnetic system;
    - formulating at least one equation associating the measured magnetic field with a hypothetical magnetic field of the magnetic system having at least one hypothetical defect introduced therein; and
    - solving the at least one formulated equation;

    **characterized in that** the method further comprises, before the step of measuring the magnetic field, the steps of:

    - introducing the at least one hypothetical defect.into the magnetic system and defining at least one parameter defining the at least one hypothetical defect;
    - simulating the hypothetical magnetic field of the magnetic system having the at least one hypothetical defect introduced therein;
    - determining points for locating the at least one magnetic field sensor (1); and
    - determining a number of measurements of the magnetic field;

    wherein the hypothetical magnetic field depends on one or more parameters defining the at least one hypothetical defect, and
    wherein values of the parameters are determined by solving the at least one formulated equation to obtain the values determining defects in the magnetic system.

2.  The method according to claim 1, further comprising, before the step of measuring the magnetic field, the step of:

    - determining location and orientation of the at least one magnetic field sensor (1).

3.  The method according to claim 1, wherein the magnetic system comprises at least one current-carrying conductor.

4.  The method according to claim 3, wherein the current-carrying conductor is a cable.

5.  The method according to claim 4, wherein the cable is a superconducting cable, the least one hypothetical defect is a cable strand breakage, and parameters defining said defect are coordinates (x, y) of the strand center point, the winding pitch (h) and the defective portion length (1).

6.  The method according to claim 3, wherein the magnetic system comprises at least one electromagnetic coil.

7.  The method according to claim 6, wherein the at least one electromagnetic coil is round, the hypothetical defects are coil ellipticity and coil warping, and parameters determining the defects are major and minor semi-axes (a, b) of the ellipse and the warping value (Y).

8.  The method according to claim 6, wherein the at least one electromagnetic coil is a tokamak toroidal field coil, wherein the defects are displacements of coil central line reference points (A,B,C,D,E,F) and parameters determining the defects are displacements of the reference points (A,B,C,D,E,F) selected along the coil contour.

9.  The method according to claim 1, wherein the magnetic system comprises at least one permanent magnet, wherein the defect of any of the at least one permanent magnet is magnetic moment (M) change of the equivalent point dipole, and parameters determining the defect are the magnetic moment (M) vector component displacement.

10. The method according to claim 1, wherein the magnetic system comprises at least two elements generating magnetic field, wherein the defects are space displacement and tilt of at least one of the elements generating magnetic field with respect to another one, and parameters determining the defects are three coordinates of the space displacement and three Euler angles of the tilt.

**11.** The method according to claim 1, wherein the magnetic system comprises at least one element generating magnetic field, wherein the defects are space displacement and tilt of the at least one element generating magnetic field and being included into the magnetic system, with respect to at least one element not included into the magnetic system or with respect to at least one element included into the magnetic system but not generating magnetic field, and parameters determining the defects are three coordinates of the space displacement and three Euler angles of the tilt.

**12.** The method according to claim 1, wherein simulation of magnetic field of the magnetic system without defects is additionally fulfilled, wherein during formulation of the at least one equation the values of the magnetic field corresponding to the magnetic system without defects are subtracted from the measured values of the magnetic system magnetic field.

**13.** The method according to claim 1, wherein during formulating the at least one equation the measured magnetic field is associated with the hypothetical magnetic field of the magnetic system at the magnetic field measurement points.

**14.** The method according to claim 1, wherein during formulating the at least one equation the hypothetical magnetic field of the magnetic system is associated with magnetic field values at the points within an area enclosing the magnetic system, the magnetic field values obtained on the base of the measured values of the magnetic field measured at the magnetic field measurement points placed at the boundary of said area, wherein the magnetic field values obtained on the base of the measured values of the magnetic field are evaluated at said points within said area through finding a solution to the boundary value problem of the Laplace equation.

**15.** The method according to claim 3, wherein measuring magnetic field is additionally carried out when the current in the magnetic system is zero, wherein such measured magnetic field values are subtracted from the magnetic field values measured with the current in the magnetic system being nonzero, and the obtained values are used to formulate the at least one equation.

**16.** The method according to claim 3, wherein measuring magnetic field is additionally carried out when the current in the magnetic system is inverse, wherein the magnetic system magnetic field values are determined through calculation of half-difference of the values of magnetic fields generated with direct and inverse current in the magnetic system, and the obtained values are used to formulate the at least one equation.

**17.** An apparatus configured for executing all the steps of method of claim 1, for determining defects in a magnetic system the apparatus comprising:

at least one magnetic field sensor (1) located outside a magnetic system, configured to measure a magnetic field of the magnetic system; and
data processing means (6) configured to:

- formulate at least one equation associating the measured magnetic field with a hypothetical magnetic field of the magnetic system having at least one hypothetical defect introduced therein, the hypothetical magnetic field depending on one or more parameters defining the at least one hypothetical defect; and
- solve the at least one formulated equation to obtain values of the parameters, the values determining defects in the magnetic system.

**18.** The apparatus according to claim 17, wherein the at least one magnetic field sensor (1) is mounted on a movable frame (4) encompassing a closed domain, wherein the apparatus is provided with means (5) for driving the movable frame and means for determining coordinates and orientation of the at least one magnetic field sensor.

**19.** The apparatus according to claim 17, wherein the at least one magnetic field sensor (1) is single-component.

**Patentansprüche**

**1.** Verfahren zur Bestimmung von Defekten in einem Magnetsystem, wobei das Verfahren die folgenden Schritte aufweist:

- Messen eines Magnetfeldes eines Magnetsystems mittels wenigstens eines außerhalb des Magnetsystems angeordneten Magnetfeldsensors (1);

- Formulieren wenigstens einer Gleichung, die das gemessene Magnetfeld mit einem hypothetischen Magnetfeld des Magnetsystems in Beziehung bringt, das wenigstens einen darin eingeführten hypothetischen Defekt hat; und

- Lösen der wenigstens einen formulierten Gleichung; **dadurch gekennzeichnet, dass** das Verfahren vor dem Schritt des Messens des Magnetfeldes ferner die folgenden Schritte aufweist:

- Einführen des wenigstens einen hypothetischen Defekts in das Magnetsystem und Definieren wenigstens eines Parameters, der den wenigstens einen hypothetischen Defekt definiert;

- Simulieren des hypothetischen Magnetfeldes des Magnetsystems, das den wenigstens einen darin eingeführten hypothetischen Defekt hat;

- Bestimmen von Punkten zur Anordnung des wenigstens einen Magnetfeldsensors (1); und

- Bestimmen einer Anzahl von Messungen des Magnetfeldes; wobei das hypothetische Magnetfeld von einem oder mehreren Parametern abhängt, die den wenigstens einen hypothetischen Defekt definieren, und

wobei Werte der Parameter durch Lösen der wenigstens einen formulierten Gleichung bestimmt werden, um die Werte zu erlangen, welche die Defekte in dem Magnetsystem bestimmen.

2. Verfahren nach Anspruch 1, das vor dem Schritt des Messens des Magnetfeldes ferner den folgenden Schritt aufweist:

- Bestimmen der Lage und Orientierung des wenigstens einen Magnetfeldsensors (1).

3. Verfahren nach Anspruch 1, wobei das Magnetsystem wenigstens einen stromführenden Leiter aufweist.

4. Verfahren nach Anspruch 3, wobei der stromführende Leiter ein Kabel ist.

5. Verfahren nach Anspruch 4, wobei das Kabel ein supraleitendes Kabel ist, der wenigstens eine hypothetische Defekt ein Kabellitzenbruch ist, und die den Defekt definierenden Parameter die Koordinaten (x, y) des Litzenmittelpunktes, der Wicklungsschritt (h) und die Länge (1) des defekten Abschnitts sind.

6. Verfahren nach Anspruch 3, wobei das Magnetsystem wenigstens eine elektromagnetische Spule aufweist.

7. Verfahren nach Anspruch 6, wobei die wenigstens eine elektromagnetische Spule rund ist, die hypothetischen Defekte Spulenelliptizität und Spulenverwindung sind, und die die Defekte bestimmenden Parameter die große und kleine Halbachse (a, b) der Ellipse und der Verwindungswert (γ) sind.

8. Verfahren nach Anspruch 6, wobei die wenigstens eine elektromagnetische Spule eine Tokamak-Toroidalfeldspule ist, wobei die Defekte Verlagerungen von Referenzpunkten (A, B, C, D, E, F) der Spulenmittellinie sind, und die die Defekte bestimmenden Parameter Verlagerungen der Referenzpunkte (A, B, C, D, E, F) sind, die entlang der Spulenkontur ausgewählt sind.

9. Verfahren nach Anspruch 1, wobei das Magnetsystem wenigstens einen Permanentmagneten aufweist, wobei der Defekt irgendeines des wenigstens einen Permanentmagneten die Änderung des Magnetmoments (M) des äquivalenten Punktdipols ist, und die den Defekt bestimmenden Parameter die Verlagerung der Vektorkomponente des Magnetmoments (M) sind.

10. Verfahren nach Anspruch 1, wobei das Magnetsystem wenigstens zwei das Magnetfeld erzeugende Elemente aufweist, wobei die Defekte Raumverlagerung und Schiefstellung wenigstens eines der das Magnetfeld erzeugenden Elemente in Bezug auf ein anderes sind, und die die Defekte bestimmenden Parameter drei Koordinaten der Raumverlagerung und drei Eulersche Winkel der Schiefstellung sind.

11. Verfahren nach Anspruch 1, wobei das Magnetsystem wenigstens ein das Magnetfeld erzeugendes Element aufweist, wobei die Defekte Raumverlagerung und Schiefstellung des wenigstens einen das Magnetfeld erzeugenden und in das Magnetsystem einbezogenen Elements in Bezug auf wenigstens ein in das Magnetsystem nicht einbezogenes Element oder in Bezug auf wenigstens ein in das Magnetsystem einbezogenes, aber das Magnetfeld nicht erzeugendes Element sind, und die die Defekte bestimmenden Parameter drei Koordinaten der Raumverlagerung und drei Eulersche Winkel der Schiefstellung sind.

12. Verfahren nach Anspruch 1, wobei die Simulation des Magnetfeldes des Magnetsystems ohne Defekte zusätzlich erfüllt ist, wobei während der Formulierung der wenigstens einen Gleichung die Werte des Magnetfeldes entsprechend dem Magnetsystem ohne Defekte von den gemessenen Werten des Magnetfeldes des Magnetsystems subtrahiert werden.

13. Verfahren nach Anspruch 1, wobei während des Formulierens der wenigstens einen Gleichung das gemessene Magnetfeld mit dem hypothetischen Magnetfeld des Magnetsystems in den Messpunkten des Magnetfeldes in Beziehung gebracht wird.

14. Verfahren nach Anspruch 1, wobei während des Formulierens der wenigstens einen Gleichung das hypothetische Magnetfeld des Magnetsystems mit Magnetfeldwerten in den Punkten innerhalb eines das Magnetsystem umschließenden Bereichs in Beziehung gebracht wird, wobei die Magnetfeldwerte, die auf der Basis der gemessenen Werte des Magnetfeldes erlangt werden, in den Magnetfeldmesspunkten gemessen werden, die an der Grenze des Bereichs platziert sind, wobei die Magnetfeldwerte, die auf der Basis der gemessenen Werte des Magnetfeldes erlangt werden, in den Punkten innerhalb des Bereichs durch Finden einer Lösung für das Grenzwertproblem der Laplaceschen Gleichung beurteilt werden.

15. Verfahren nach Anspruch 3, wobei das Messen des Magnetfeldes zusätzlich durchgeführt wird, wenn der Strom in dem Magnetsystem Null ist, wobei solche gemessenen Magnetfeldwerte von den Magnetfeldwerten subtrahiert werden, die mit dem Strom in dem Magnetsystem, der nicht Null ist, gemessen werden, und die erlangten Werte verwendet werden, um die wenigstens eine Gleichung zu formulieren.

16. Verfahren nach Anspruch 3, wobei das Messen des Magnetfeldes zusätzlich durchgeführt wird, wenn der Strom in dem Magnetsystem invers ist, wobei die Werte des Magnetfeldes des Magnetsystems durch Berechnung der halben Differenz der mit dem direkten und inversen Strom in dem Magnetsystem erzeugten Werte der Magnetfelder bestimmt werden, und die erlangten Werte verwendet werden, um die wenigstens eine Gleichung zu formulieren.

17. Vorrichtung, die zur Durchführung aller Schritte des Verfahrens nach Anspruch 1 zur Bestimmung von Defekten in einem Magnetsystem konfiguriert ist, wobei die Vorrichtung aufweist:

wenigstens einen außerhalb eines Magnetsystems angeordneten Magnetfeldsensor (1), der konfiguriert ist, um ein Magnetfeld des Magnetsystems zu messen; und
Datenverarbeitungsmittel (6), die konfiguriert sind, um:

- wenigstens eine Gleichung zu formulieren, die das gemessene Magnetfeld mit einem hypothetischen Magnetfeld des Magnetsystems in Beziehung bringt, das wenigstens einen darin eingeführten hypothetischen Defekt hat, wobei das hypothetische Magnetfeld von einem oder mehreren Parametern abhängt, die den wenigstens einen hypothetischen Defekt definieren; und
- die wenigstens eine formulierte Gleichung zu lösen, um Werte der Parameter zu erlangen, wobei die Werte Defekte in dem Magnetsystem bestimmen.

18. Vorrichtung nach Anspruch 17, wobei der wenigstens eine Magnetfeldsensor (1) an einem beweglichen Rahmen (4) montiert ist, der einen geschlossenen Bereich umschließt, wobei die Vorrichtung mit Mitteln (5) zum Antreiben des beweglichen Rahmens und Mitteln zum Bestimmen von Koordinaten und der Orientierung des wenigstens einen Magnetfeldsensors versehen ist.

19. Vorrichtung nach Anspruch 17, wobei der wenigstens eine Magnetfeldsensor (1) eine Einzelkomponente ist.

**Revendications**

1. Procédé destiné à déterminer des défauts dans un système magnétique, le procédé comprenant les étapes de :

- mesure, en utilisant au moins un capteur de champ magnétique (1) situé en dehors d'un système magnétique, d'un champ magnétique du système magnétique ;
- formulation d'au moins une équation associant le champ magnétique mesuré à un champ magnétique hypothétique du système magnétique dans lequel est introduit au moins un défaut hypothétique ; et
- résolution de la au moins une équation formulée ;

**caractérisé en ce que** le procédé comprend en outre, avant l'étape de mesure du champ magnétique, les étapes de :

- introduction du au moins un défaut hypothétique dans le système magnétique et définition d'au moins un paramètre définissant le au moins un défaut hypothétique ;
- simulation du champ magnétique hypothétique du système magnétique dans lequel est introduit le au moins un défaut hypothétique ;
- détermination des points afin de localiser le au moins un capteur de champ magnétique (1) ; et
- détermination d'un certain nombre de mesures du champ magnétique ;

dans lequel le champ magnétique hypothétique dépend d'un ou plusieurs paramètres définissant le au moins un défaut hypothétique ; et

dans lequel les valeurs des paramètres sont déterminées en résolvant la au moins une équation formulée afin d'obtenir les valeurs déterminant des défauts dans le système magnétique.

2. Procédé selon la revendication 1, comprenant en outre, avant l'étape de mesure du champ magnétique, l'étape de :

- détermination de l'emplacement et de l'orientation du au moins un capteur de champ magnétique (1).

3. Procédé selon la revendication 1, dans lequel le système magnétique comprend au moins un conducteur d'acheminement de courant.

4. Procédé selon la revendication 3, dans lequel le conducteur d'acheminement de courant est un câble.

5. Procédé selon la revendication 4, dans lequel le câble est un câble supraconducteur, le au moins un défaut hypothétique est une rupture de toron de câble, et les paramètres définissant ledit défaut sont les coordonnées (x, y) du point central du toron, le pas de bobinage (h) et la longueur de la partie défectueuse (1).

6. Procédé selon la revendication 3, dans lequel le système magnétique comprend au moins une bobine électromagnétique.

7. Procédé selon la revendication 6, dans lequel la au moins une bobine électromagnétique est ronde, les défauts hypothétiques sont une ellipticité de bobine et un gauchissement de bobine, et les paramètres déterminant les défauts sont les demi grand axe et demi petit axe (a, b) de l'ellipse et la valeur du gauchissement (Y).

8. Procédé selon la revendication 6, dans lequel la au moins une bobine électromagnétique est une bobine de champ toroïdal de tokamak, dans lequel les défauts sont des déplacements de points de référence de la ligne centrale de la bobine (A, B, C, D, E, F) et les paramètres déterminant les défauts sont des déplacements des points de référence (A, B, C, D, E, F) sélectionnés le long du contour de la bobine.

9. Procédé selon la revendication 1, dans lequel le système magnétique comprend au moins un aimant permanent, dans lequel le défaut de n'importe lequel du au moins un aimant permanent est une modification du moment magnétique (M) du dipôle ponctuel équivalent, et les paramètres déterminant le défaut sont le déplacement d'une composante vectorielle du moment magnétique (M).

10. Procédé selon la revendication 1, dans lequel le système magnétique comprend au moins deux éléments générant un champ magnétique, dans lequel les défauts sont un déplacement spatial et une inclinaison d'au moins un des éléments générant un champ magnétique par rapport à un autre, et les paramètres déterminant les défauts sont trois coordonnées du déplacement spatial et trois angles d'Euler de l'inclinaison.

11. Procédé selon la revendication 1, dans lequel le système magnétique comprend au moins un élément générant un champ magnétique, dans lequel les défauts sont un déplacement spatial et un inclinaison du au moins un élément générant un champ magnétique et qui sont inclus dans le système magnétique, par rapport à au moins un élément non inclus dans le système magnétique ou par rapport à au moins un élément inclus dans le système magnétique mais ne générant pas de champ magnétique, et les paramètres déterminant les défauts sont trois coordonnées du déplacement spatial et trois angles d'Euler de l'inclinaison.

12. Procédé selon la revendication 1, dans lequel une simulation de champ magnétique du système magnétique sans défauts est en outre exécutée, dans lequel au cours de la formulation de la au moins une équation, les valeurs du champ magnétique correspondant au système magnétique sans défauts sont soustraites des valeurs mesurées du champ magnétique du système magnétique.

13. Procédé selon la revendication 1, dans lequel, pendant la formulation de la au moins une équation, le champ magnétique mesuré est associé au champ magnétique hypothétique du système magnétique au niveau des points de mesure du champ magnétique.

14. Procédé selon la revendication 1, dans lequel, pendant la formulation de la au moins une équation, le champ magnétique hypothétique du système magnétique est associé aux valeurs de champ magnétique au niveau des points à l'intérieur d'une zone englobant le système magnétique, aux valeurs de champ magnétique obtenues sur la base des valeurs mesurées du champ magnétique mesuré au niveau des points de mesure du champ magnétique placés à la limite de ladite zone, dans lequel les valeurs de champ magnétique obtenues sur la base des valeurs mesurées du champ magnétique sont évaluées au niveau desdits points à l'intérieur de ladite zone en trouvant une solution au problème de la valeur limite de l'équation de Laplace.

15. Procédé selon la revendication 3, dans lequel la mesure du champ magnétique est en outre exécutée lorsque le courant dans le système magnétique est égal à zéro, dans lequel les valeurs de champ magnétique ainsi mesuré sont soustraites des valeurs de champ magnétique mesuré lorsque le courant dans le système magnétique est différent de zéro, et les valeurs obtenues sont utilisées pour formuler la au moins une équation.

16. Procédé selon la revendication 3, dans lequel la mesure du champ magnétique est en outre exécutée lorsque le courant dans le système magnétique est inverse, dans lequel les valeurs de champ magnétique du système magnétique sont déterminées grâce à un calcul de la demi-différence des valeurs des champs magnétiques générés avec un courant direct et inverse dans le système magnétique, et les valeurs obtenues sont utilisées pour formuler la au moins une équation.

17. Appareil configuré pour exécuter toutes les étapes du procédé de la revendication 1, destiné à déterminer des défauts dans un système magnétique, l'appareil comprenant :

   au moins un capteur de champ magnétique (1) situé en dehors d'un système magnétique, configuré pour mesurer un champ magnétique du système magnétique ; et
   un moyen de traitement de données (6) configuré pour :

      - formuler au moins une équation associant le champ magnétique mesuré à un champ magnétique hypothétique du système magnétique dans lequel est introduit au moins un défaut hypothétique, le champ magnétique hypothétique dépendant d'un ou de plusieurs paramètres définissant le au moins un défaut hypothétique ; et
      - résoudre la au moins une équation formulée pour obtenir les valeurs des paramètres, les valeurs déterminant des défauts dans le système magnétique.

18. Appareil selon la revendication 17, dans lequel le au moins un capteur de champ magnétique (1) est monté sur un bâti mobile (4) entourant un domaine fermé, dans lequel l'appareil est doté de moyens (5) pour commander le bâti mobile et de moyens pour déterminer les coordonnées et l'orientation du au moins un capteur de champ magnétique.

19. Appareil selon la revendication 17, dans lequel le au moins un capteur de champ magnétique (1) est un composant unique.

Fig.1

Fig. 2

Fig. 3

Fig. 4

Fig. 5

Fig. 6

Fig. 7

Fig. 8

Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2001054509 A1
- RU 2197013
- RU 2241958

- US 5654635 A
- RU 2271549


**Non-patent literature cited in the description**

- **I.E. TAMM.** *Bases of the Electricity Theory,* 1989
- **DUKE A.E. et al.** Coupled Electromagnetic and Thermohydraulic Analysis of ITER Cable Joint. *IEEE TRANSACTIONS ON APPLIED SUPERCONDUCTIVITY,* June 1997, vol. 7 (2
- **BELYAKOV V. et al.** Plasma control in Tokamaks. *Physics and Control, Proc. Intern. Conf. Saint Petersburg,* 24 August 2005, 920-927

- **M.L. BARANOCHNIKOV.** Micromagnetoelectronics. DMK-Press, 2001, vol. 1-2
- **AFANASIEV U.V. ; STUDENTSOV N.V. ; SCHEPKIN A.P.** *Magnetometric converters, devices, apparatuses,* 1972
- **PURCELL E.** *Electricity and Magnetism*
- **TIKHONOV A.N. ; ARSENIN V.Y.** *Methods of incorrect problem solving,* 1986
- **DEMIDOVICH B.P. ; MARON I.A.** *Bases of the calculus mathematics,* 1970